# EUROPEAN PATENT SPECIFICATION

(11) **EP 2 916 364 B1**
(45) Date of publication and mention of the grant of the patent: **20.12.2017**
(21) Application number: 14305331.2
(22) Date of filing: 07.03.2014
(51) Int. Cl.: H01L 41/053

(54) **TRANSLATION APPARATUS FOR MOVING AN OBJECT OUTSIDE A HOUSING OF THE TRANSLATION APPARATUS, TRANSLATION SYSTEM AND RF COMPONENT FOR MOBILE COMMUNICATION THEREOF**
ÜBERSETZUNGSVORRICHTUNG ZUM BEWEGEN EINES GEGENSTANDS AUSSERHALB EINES GEHÄUSES DER ÜBERSETZUNGSVORRICHTUNG, ÜBERSETZUNGSSYSTEM UND HF-BAUTEIL ZUR MOBILEN KOMMUNIKATION DAMIT
APPAREIL DE TRANSLATION POUR DÉPLACER UN OBJET À L'EXTÉRIEUR D'UN BOÎTIER DE L'APPAREIL DE TRANSLATION, SYSTÈME DE TRANSLATION ET COMPOSANT RF POUR COMMUNICATION MOBILE ASSOCIÉE

(43) Date of publication of application: 09.09.2015
(73) Proprietor: ALCATEL LUCENT, 92100 Boulogne-Billancourt (FR)
(72) Inventor: Wiegner, Dirk, 70435 Stuttgart (DE); Templ, Wolfgang, 70435 Stuttgart (DE); Pascht, Andreas, 70435 Stuttgart (DE)
(74) Representative: Wetzel, Emmanuelle

(56) References cited:
- WO-A2-01/06579
- DE-A1-102012 215 548

## Description

### FIELD OF THE INVENTION

The present invention relates to a translation apparatus and, more particularly but not exclusively, to tuning of RF components by the translation apparatus.

### BACKGROUND

This section introduces aspects that may be helpful in facilitating a better understanding of the invention. Accordingly, the statements of this section are to be read in this light and are not to be understood as admission about what is in the prior art.

In mobile communication, adaptive tunable RF components (RF = radio frequency), such as filters or antennas are helpful, in order to increase flexibility and sustainability of radio communication systems and to reduce cost. Very often, flexibility can only be achieved with high effort and reduced performance.

Today's radio communication systems need to cover a wide range of the RF spectrum. Radio transmitter carrier frequencies in 4G and 5G wireless systems vary between 700 MHz and 4 GHz.

With respect to antenna systems, positions of antenna elements of a phased antenna array in normal direction to the antenna array plane need to be adjusted for adapting a beam steering of the phased antenna array to a predefined direction. Thereby, signal phases of the individual antenna elements need to be shifted relatively to each other very precisely by a certain degree. Therefore, a movement in vertical direction to the antenna array (e.g. a movement of one antenna element towards a neighboring antenna element) shall be prevented. In addition, if a large antenna array is used, adjusting devices or adjustment units for each antenna element should be small, reliable, cheap, and should have a low weight.

Using servo/step motor drives to move antenna elements of the phases antenna array and thus to control and to change a beam steering direction of the phased antenna array implies high system complexity, cost and failure probability.

Using alternatively the well-known piezo-electrical effect by means of a piezoelectric drive suffers from a small expansion of a piezoelectric drive and thus provides only a small tuning range.

WO 01/06579 A2 discloses electroactive polymers that are pre-strained to improve conversion from electrical to mechanical energy. DE 10 2012 215548 A1 discloses an actor for an exhaust gas turbocharger.

### SUMMARY

Thus, objects of the embodiments of the invention are increasing tuning ranges with respect to piezoelectric drives and system performance and reducing system tuning effort, system complexity, installation and operation, precision of adjustment and failure probability.

The object is achieved by a translation apparatus according to claim 1.

The object is further achieved by a translation system, which contains at least two translation apparatuses. A first one of the at least two translation apparatuses is mounted at a second one of the at least two translation apparatuses and an expansion or contraction direction of the first one of the at least two translation apparatuses is perpendicular arranged with respect to a further expansion or contraction direction of the second one of the at least two translation apparatuses for a movement of the object in a first direction and at least one second direction being perpendicular to the first direction.

The object is even further achieved by an RF component for mobile communication which contains the translation apparatus. The translation apparatus is adapted for adjusting a position or orientation of at least one subunit of the RF component. In alternative embodiments, the RF component may contain two or more of the above described and in the following described translation apparatuses.

The RF component may be for example an antenna system and the at least one subunit may be for example at least one antenna element.

The proposed translation apparatus provides a main advantage based on the housing, which may be also a casing or a containment and based on the sliding unit of the translation apparatus to force the extensible material to expand or to compress predominantly in a single direction, which is the movement direction of the sliding unit. Thereby, the translation apparatus obtains a preferred and single direction of extension or compression. This allows applying also extensible materials within the housing of the translation apparatus, which don't have a single predominant direction of expansion. Further advantages are increased tuning ranges with respect to piezoelectric drives and increased system performance, reduced system tuning effort, reduced system complexity, reduced installation costs, reduced operation costs, increased precision of adjustment and reduced failure probability. By the expansion and contraction in the linear direction a high precision for adjusting the translation apparatus may be obtained.

Advantageously, the housing comprises a first recipient and at least one second recipient. Thereby, the sliding unit may be based on a shiftable arrangement of the first recipient in an opening of a base of the at least one second recipient. The at least one second recipient may be adapted to contain at least partly the first recipient in a non-expanded state of the translation apparatus and the at least one second recipient may be adapted to uncover at least partly the first recipient in an expanded state of the translation apparatus.

The first recipient may have for example a form of a first cup and the at least second recipient may have for example a form of at least one second cup.

With respect to the first preferred embodiment, the first electrical contact surface may be preferably arranged at a first inner end face of the housing and the second electrical contact surface may be arranged at a second inner end face of the housing being opposite to the first inner end face. The first inner end face and the second inner end face may be arranged with a surface normal being parallel to a movement direction of the object. This means, that the first inner end face and the second inner end face are inner end faces of the housing in a longitudinal direction of the housing and the longitudinal direction is parallel to the movement direction. In an alternative embodiment with a properly less expansion effect and/or contraction effect, at least one of the first inner end face and the second inner end face may be arranged with a surface normal being perpendicular to the movement direction.

In one embodiment, the translation apparatus may further contain the object being mounted on an outer surface of the housing. Preferably, a surface normal of the outer surface may be parallel arranged with respect to the movement direction.

In an example, the translation apparatus contains a movable part externally arranged to the housing and a piston shiftable arranged inside the housing. The piston is adapted to move the movable part by the expansion or by the contraction of the extensible material. The example provides the advantage, that in comparison to known hydraulic or pneumatic systems using air or liquids which require a pump into the cavity and a pump out from the cavity, the extensible material does not need to be pumped into the cavity and to pump out from the cavity, but the movement is achieved by the fact, that the extensible material extends or contracts by applying suitable related control voltages. Known hydraulic or pneumatic systems often require in addition a power gear ratio or a force reduction which is not required with respect to the second embodiment.

With respect to the example, the first electrical contact surface may be arranged at an inner end face of the housing and the inner end face may be perpendicular arranged with respect to the movement direction. The second electrical contact surface may be arranged at an end face of the recipient which faces towards the inner end face of the housing. The end face of the recipient may be also perpendicular move the movable part by the expansion or by the contraction of the extensible material. The second preferred embodiment provides the advantage, that in comparison to known hydraulic or pneumatic systems using air or liquids which require a pump into the cavity and a pump out from the cavity, the extensible material does not need to be pumped into the cavity and to pump out from the cavity, but the movement is achieved by the fact, that the extensible material extends or contracts by applying suitable related control voltages. Known hydraulic or pneumatic systems often require in addition a power gear ratio or a force reduction which is not required with respect to the second embodiment.

With respect to the second preferred embodiment, the first electrical contact surface may be arranged at an inner end face of the housing and the inner end face may be perpendicular arranged with respect to the movement direction. The second electrical contact surface may be arranged at an end face of the recipient which faces towards the inner end face of the housing. The end face of the recipient may be also perpendicular arranged with respect to the movement direction. In an alternative embodiment with a possibly less expansion effect and/or contraction effect, the inner end face may be arranged with a surface normal being perpendicular to the movement direction.

In one embodiment, the translation apparatus further contains the object and the object may be preferably mounted on the movable part.

In two further embodiments, the housing may contain or may consist of a non-conductive material or the housing may contain or may consist of a conductive material and an inner surface of the housing may contain an isolation layer between the conductive material and the extensible material. In both cases, leakage currents flowing via the housing may be prevented.

In one embodiment, the extensible material may be adapted to expand if the control voltage exceeds a predefined threshold value and the extensible material may be further adapted to compress if the control voltage falls below the predefined threshold value or falls below a further predefined threshold value, which is smaller than the predefined threshold value.

In further preferred embodiments, the extensible material may contain or may consist of an ionic electro-active polymer or a dielectric electro-active polymer. For protecting the polymer and for avoiding a leakage from the housing, the housing may be preferably a sealed housing for the polymer.

In one embodiment, the electro-active polymer may have at least two directions of deflection. Due to the housing and the sliding unit, a capability of the polymer for moving the sliding unit is not reduced by the at least two directions of deflection because the expansion or compression of the polymer is guided by the housing and the sliding unit.

Further advantageous features of the embodiments of the invention are defined in the dependent claims and are described in the following detailed description.

### BRIEF DESCRIPTION OF THE FIGURES

The embodiments of the invention will become apparent in the following detailed description and will be illustrated by accompanying figures given by way of non-limiting illustrations.
Figures 1 a), 1 b), 1 c) and 1 d) show schematically four block diagrams of a translation apparatus according to a first exemplary embodiment.
Figures 2 a) and 2 b) show schematically two block diagrams of a translation apparatus according to a second exemplary embodiment.
Figures 3 a), 3 b), 3 c) and 3 d) show schematically four block diagrams of a translation apparatus according to a third exemplary embodiment.
Figures 4 a) and 4 b) show schematically two block diagrams of a translation apparatus according to a fourth exemplary embodiment.
Figure 5 shows schematically a block diagram of a network node for radio communication which contains a transceiver unit and an antenna system. The antenna system contains several antenna elements and several translation apparatuses for an adjustment of positions of the antenna elements for controlling a beam steering according to an exemplary embodiment.

### DESCRIPTION OF THE EMBODIMENTS

The description and drawings merely illustrate the principles of the invention. It will thus be appreciated that those skilled in the art will be able to devise various arrangements that, although not explicitly described or shown herein, embody the principles of the invention. Furthermore, all examples recited herein are principally intended expressly to be only for pedagogical purposes to aid the reader in understanding the principles of the invention and the concepts contributed by the inventors to furthering the art, and are to be construed as being without limitation to such specifically recited examples and conditions.

A splitting of processing functions across processing units shown in the Figures is not critical, and as can be understood by those skilled in the art that the number of processing units, the number of processing functions and an allocation of the processing functions to the processing units may vary without departing from the scope of the embodiments of the invention as defined in the appended claims.

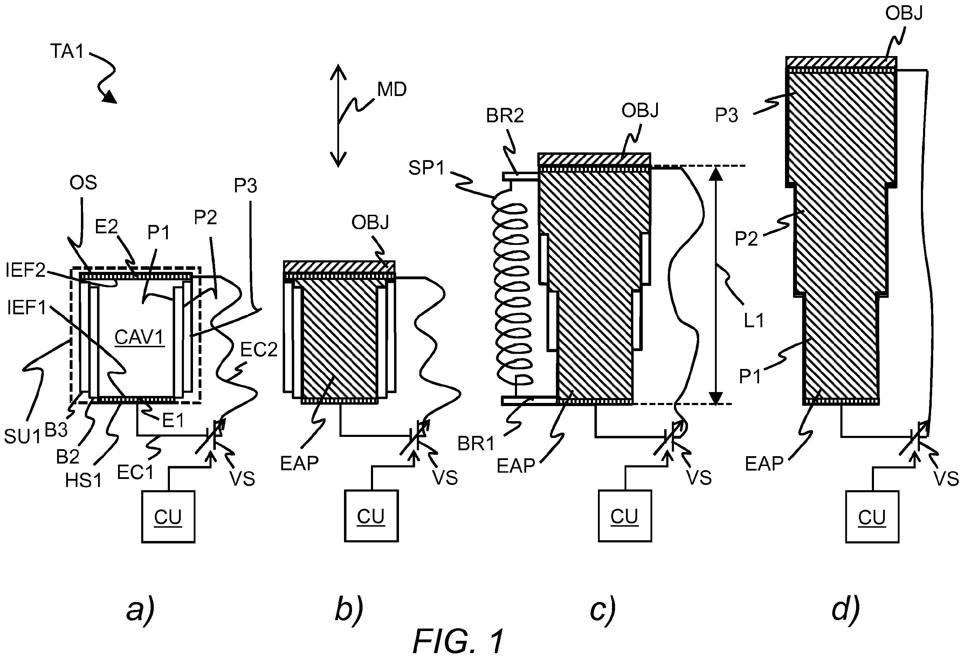

Figure 1 shows schematically four block diagrams of a translation apparatus TA1 according to a first exemplary embodiment. The translation apparatus TA1 which is shown in Figure 1 a) contains three recipients P1, P2, P3 which are put into one another. Each of the recipients P1, P2, P3 may have a form of a cup or a beaker which contains preferably a circular wall. A first recipient P1 with a smallest outer diameter may be arranged in a lowest position and further contains a bottom or ground or a first electrode E1 may be applied as the bottom or ground. A second recipient P2, which contains partly the first recipient P1, neither has a bottom or cover. A third recipient P3, which contains partly the second recipient P2, further contains a cover. The translation apparatus TA1 may be also applicable for the object of the invention, when rotated by 180° from bottom to top.

Alternatively, the walls of the recipients P1, P2, P3 may have a square form or a rectangular form. The second recipient P2 contains a first recipient P1 in such a way, that an outer diameter of the first recipient P1 is adapted to an opening of a base B2 of the second recipient P2 so that the second recipient P2 is shiftable arranged with respect to the first recipient P1. In a similar way, the third recipient P3 contains the second recipient P2 in such a way, that an outer diameter of the second recipient P2 is adapted to an opening of a base B3 of the third recipient P3 so that the third recipient P3 is shiftable arranged with respect to the second recipient P2.

The third recipient P3 preferably contains a cover or a second electrode E2 may be applied as the cover. In addition, an anti-friction agent such as oil may be inserted between the walls of the recipients P1, P2, P3. Thereby, a shifting between the recipients P1, P2, P3 is facilitated and an arrangement of the three recipients P1, P2 and P3 provides a sealed housing HS1. The housing HS1 provides a cavity CAV1 within the housing HS1.

The housing HS1 may contain or may consist preferably of a non-conductive material. Alternatively, the housing HS1 may contain or may consist of a conductive material and an inner surface of the housing HS1 may contain an isolation layer such as PTFE (PTFE = Polytetrafluorethylen), FEP (FEP = Fluorethylenpropylen), or PFA (PFA = Perfluorakoxy). Thereby, an electrical isolation between the conductive material of the housing HS1 and the extensible material EAP may be obtained.

The arrangement of the three recipients P1, P2, and P3 further add up to a sliding unit SU1 as part of the translation apparatus TA1. According to further alternatives, the translation apparatus TA1 and thereby the sliding unit SU1 may contain only two recipients or more than three recipients, which depends on a maximum required length or height adjustment way and further depends on a length extension capability of the extensible material EAP. The two recipients or the more than three recipients may be arranged in a longitudinal direction of the translation apparatus TA1 which is the expansion direction and contraction direction. For example, if the extensible material EAP may be able to expand only by 30 percent or 50 percent, the translation apparatus TA1 may contain only the first recipient P1 and the second recipient P2.

In one embodiment as shown in Figure 1, the recipients P1, P2, P3 may have a same height. According to further embodiments, the recipients P1, P2, P3 may have different heights.

The translation apparatus TA1 further contains the first electrode E1 preferably at a first inner end face IEF1 of the housing HS1 and the second electrode E2 preferably at a second inner end face IEF2 of the housing HS1 which is opposite to the first inner end face IEF1. The first electrode E1 and the second electrode E2 may be for example plane electrodes with an outer diameter which is adapted and fits to an inner diameter of the housing HS1.

The first electrode E1 is preferably arranged at a bottom of the first recipient P1. This means that the first inner end face IEF1 may be an inner surface of the bottom of the base of the first recipient P1. A first electrical connection EC1 to the first electrode E1 is preferably provided by a feed through via the bottom of the first recipient P1 (see Figure 1 a).

The second electrode E2 is preferably arranged centrally at a top edge of the third recipient P3. This means that the second inner end face IEF2 may be an inner surface of the cover of the third recipient P3. A second electrical connection EC2 to the second electrode E2 is preferably provided by a further feed through via an upper part of a wall of the third recipient P3 (see Figure 1 a).

The first electrical connection EC1 and the second electrical connection EC2 are connectable to a controllable voltage source VS.

In alternative embodiments, at least one of the first electrode E1 and the second electrode E2 may be arranged at an inner surface of the first recipient P1 which has a surface normal being perpendicular arranged to a movement direction MD of the translation apparatus TA1.

The translation apparatus TA1 may further contain the controllable voltage source VS and a control unit CU for controlling an output voltage of the controllable voltage source VS which is applied to the electrodes E1, E2 of the translation apparatus TA1. In such a case (as shown in Figure 1 a), the first electrical connection EC1 is connected to a first terminal of the controllable voltage source VS and the second electrical connection EC2 is connected to a second terminal of the controllable voltage source VS.

The translation apparatus TA1 which is shown in Figure 1 b) further contains an extensible material EAP which is filled into the cavity CAV1 of the housing HS1 and which is in contact with the first electrode E1 and the second electrode E2. The extensible material EAP is adapted to expand or to contract if the output voltage of the controllable voltage source VS is applied to the first electrode E1 and to the second electrode E2. Thereby, the sliding unit SU1 is adapted to move in the movement direction MD by an expansion or by a contraction of the extensible material EAP. Preferably, the sliding unit SU1 is adapted to move in a single linear movement direction being the movement direction MD by the expansion or by the contraction of the extensible material EAP.

The expansion is achieved by an internal pressure, which is obtained when the extensible material EAP presses against the walls of the housing HS1 by increasing the output voltage.

The contraction may be achieved for example by a gravitational force. When the gravitational force cannot be used dependent on an orientation of the translation apparatus TA1 or when the gravitational force is not large enough for a backward motion of the sliding unit SU1, the translation apparatus TA1 may preferably further contain means for providing a reset force for the sliding unit SU1. The reset force may be provided for example by a fixation of the extensible material EAP at the cover of the third recipient for example by gluing. Alternatively, when gluing provides no stable fixation the translation apparatus TA1 may further contain a kind of barb, which is fixed at the cover of the third recipient P3 and which extends on its other side into the cavity CAV1 and the extensible material EAP in such a way, that the extensible material EAP entangles at the barb.

A further possibility for providing the reset force is shown with respect to Figure 1 c) (only shown in Figure 1 c) for simplification). A first bracket BR1 may be fixed outside of the housing HS1 to a lower part of the first recipient P1 and a second bracket BR2 may be fixed outside of the housing HS2 to an upper part of the third recipient P3. A spring SP1 may be arranged between the first bracket BR1 and the second bracket BR2 and the spring SP1 may be fixed with a first end at the first bracket BR1 and with a second end at the second bracket BR2. A reset force of the spring SP1 is below an expansion force of the extensible material EAP and above an inert force of the housing HS1. In a preferred embodiment, the translation apparatus TA1 may contain a further spring at an opposite outer surface of the housing HS1 for avoiding any shear forces (not shown in Figure 1 c) for simplification).

The extensible material EAP may be adapted to expand if the output voltage exceeds a predefined threshold value and the extensible material EAP may be adapted for being completely compressed if the output voltage falls below the predefined threshold value or below a further predefined value smaller than the predefined value when a hysteresis behavior of the extensible material prevents a contraction of the extensible material and thereby a backward motion of the sliding unit SU1.

The extensible material EAP may be preferably an ionic electro-active polymer or a dielectric electro-active polymer. By using the housing HS1, the ionic electro-active polymer or the dielectric electro-active polymer does not need to have only a single direction of deflection. This means based on the theory of elasticity, that the ionic electro-active polymer or the dielectric electro-active polymer may have a single direction of deflection if a mass density changes by an application of the output voltage of the controllable voltage source VS. Alternatively, the ionic electro-active polymer or the dielectric electro-active polymer may have more than one direction of deflection if a mass density doesn't change or changes only to some extend by an application of the output voltage of the controllable voltage source VS, which means that a contraction in a first direction comes along with a dilatation in a second direction, which may be for example perpendicular to the first direction.

The extensible material EAP may be alternatively an IPMC (IPMC = Ionic Polymer Metal Composite), Polyacrylamide and Polayacrylic acid cross- linked gels, Carbon Nanotube based EAPs, VHB (VHB = Very High Bond; a network of polymers, which is provided commercially as a tape from 3M Company), VHB-TMPTMA interpenetration networks (TMPTMA = trimethylolpropane trimethacrylat).

The translation apparatus TA1 may further contain an object OBJ outside the housing HS1 of the translation apparatus TA1 and attached to an outer surface OS of the housing HS1. A surface normal of the outer surface OS may be preferably arranged in parallel to the movement direction MD of the translation apparatus TA1. The object OBJ may be for example attached to the outer surface OS by an adhesive bond if for example an electrical isolation or a thermal isolation is required or may be affixed by a screw fitting.

In a non-expanded state of the translation apparatus TA1 as shown in Figure 1 b), the extensible material EAP may be fully compressed and the second recipient P2 and the third recipient P3 are adapted to contain at least partly the first recipient P1. The non-expanded state of the translation apparatus TA1 may be obtained by a first predefined value of the output voltage of the controllable voltage source VS to be applied to the extensible material EAP.

Figure 1 c) shows the translation apparatus TA1 in an intermediate state between the non-expanded state as shown in Figure 1 b) and a fully-expanded state as shown by Figure 1 d). The intermediate state with a desired length L1 of the translation apparatus TA1 between the bottom of the first recipient P1 and the upper edge of the third recipient P3 may be obtained by a second predefined value of the output voltage of the controllable voltage source VS larger than the first predefined value.

In the intermediate state, the second recipient P2 is adapted to uncover at least partly the first recipient P1 and the third recipient P3 is adapted to uncover at least partly the second recipient P2 as shown in Figure 1 c).

Figure 1 d) shows the translation apparatus TA1 in the fully-expanded state. The fully-expanded state of the translation apparatus TA1 may be obtained by a third predefined value of the output voltage of the controllable voltage source VS larger than the second predefined value. By the fully-expanded state, the second recipient P2 may be adapted to almost (except for a small overlap, which is used as a closure and lock) fully uncover the first recipient P1 and the third recipient P3 may be adapted to fully almost (except for a further small overlap, which is used as a further closure and further lock) uncover the second recipient P2 as shown in Figure 1 d).

An expansion or contraction of the translation apparatus TA1 may depend linearly from the output voltage of the controllable voltage source VS to be applied to the extensible material EAP. If alternatively, the expansion of the translation apparatus TA1 does not depend linearly from the output voltage of the controllable voltage source VS, a value table may be applied within the control unit CU for adjusting the translation apparatus TA1 with the desired length L1.

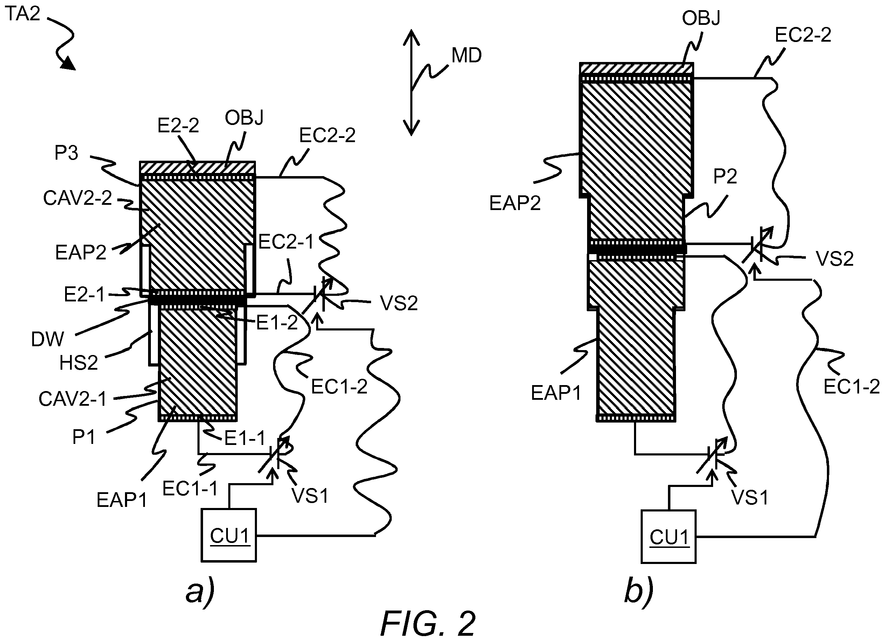

Figure 2 shows schematically two block diagrams of a translation apparatus TA2 according to a second exemplary embodiment. The translation apparatus TA2 which is shown in Figure 2 a) may be similar to the translation apparatus TA1 as shown in Figure 1 c) with following differences:

The translation apparatus TA2 exemplarily contains the first recipient P1, the second recipient P2, the third recipient P3, a first extensible material EAP1, a second extensible material EAP2, a first electrode E1-1, a second electrode E1-2, a third electrode E2-1, a fourth electrode E2-2, a first electrical connection EC1-1 connected to the first electrode E1-1, a second electrical connection connected to the second electrode E1-2, a third electrical connection connected to the third electrode E1-3, a fourth electrical connection connected to the fourth electrode E2-2 and a dividing wall DW between a first cavity CAV2-1 and a second cavity CAV2-2.

Instead of only one extensible material, two or more extensible materials may be stacked for example in two or more separate cavities for being able to achieve a sufficient large expansion of the translation apparatus TA2. The translation apparatus TA2 contains the dividing wall DW preferably arranged perpendicular to the movement direction MD at an upper border of the first recipient P1 and at a lower border of the third recipient P3 in an unexpanded state of the first extensible material EAP1 and the second extensible material EAP2. Thereby, a housing HS2 of the translation apparatus TA2 contains the first lower cavity CAV2-1 being filled with the first extensible material EAP1 and the second upper cavity CAV2-2 being filled with the second extensible material EAP2.

The first extensible material EAP1 and the second extensible material EAP2 may a same extensible material as being explained with respect to the extensible material EAP being described for the translation apparatus TA1 or may be two different extensible materials from the group of extensible materials as described with respect to the extensible material EAP.

The recipients of the translation apparatus TA2 may have a form of one of the alternatives as being described for the recipients P1, P2 and P3 of the translation apparatus TA1. A number of the recipients may be based on one of the alternatives as being described with respect to the translation apparatus TA1. A material of the housing HS2 may be based on one of the alternatives as being described with respect to the housing HS1.

The first electrode E1-1 is preferably arranged at the base or bottom of the first recipient P1 and the second electrode E1-2 is preferably arranged at a lower end face of the diving wall DW which is opposite to the base of the first recipient P1. The first electrode E1-1 and the second electrode E1-2 may be for example plane electrodes with an outer diameter which is adapted and fits to an inner diameter of the first recipient P1.

The first electrical connection EC1-1 to the first electrode E1-1 is preferably provided by a feed through via the bottom of the first recipient P1 (see Figure 2 a). The second electrical connection EC1-2 to the second electrode E1-2 may be provided for example by a sliding contact. Alternatively, the second electrode E1-2 may be placed at a sidewall of the first cavity 2-1. The first electrical connection EC1 and the second electrical connection EC2 are connectable to a first controllable voltage source VS1.

The fourth electrode E2-2 is preferably arranged at the upper part of the third recipient P3 and the third electrode E2-1 is preferably arranged at an upper end face of the diving wall DW which is opposite to the upper part of the third recipient P3. The third electrode E2-1 may be for example a plane electrode with an outer diameter which is adapted and fits to an inner diameter of the second recipient P2 and the fourth electrode E2-2 may be for example a plane electrode with an outer diameter which is adapted and fits to an inner diameter of the third recipient P3.

The fourth electrical connection EC2-2 to the fourth electrode E2-2 is preferably provided by a feed through via a border of the third recipient P3 (see Figure 2 a). The third electrical connection EC2-1 to the third electrode E2-1 may be provided for example by a further sliding contact. Alternatively, the third electrode E2-1 may be placed at a sidewall of the second cavity C2-2. The third electrical connection EC2-1 and the fourth electrical connection EC2-2 are connectable to a second controllable voltage source VS2.

In alternative embodiment, at least one of the first electrode E1-1, the second electrode E1-2, the third electrode E2-1 and the fourth electrode E2-2 may be arranged at an inner surface of the housing HS2 which has a surface normal being perpendicular arranged to the movement direction MD of the translation apparatus TA2.

The translation apparatus TA2 may further contain the first controllable voltage source VS1, the second controllable voltage source VS2 and a control unit CU1 for controlling an output voltage of the first controllable voltage source VS1 which is applied to the electrodes E1-1, E1-2 and for controlling a further output voltage of the second controllable voltage source VS2 which is applied to the electrodes E2-1, E2-2. In such a case (as shown in Figure 2 a), the first electrical connection EC1-1 is connected to a first terminal of the first controllable voltage source VS1, the second electrical connection EC1-2 is connected to a second terminal of the first controllable voltage source VS1, the third electrical connection EC2-1 is connected to a first terminal of the second controllable voltage source VS2 and the fourth electrical connection EC2-2 is connected to a second terminal of the second controllable voltage source VS2.

The contraction of the first extensible material EAP1 and of the second extensible material EAP2 may be achieved for example by a gravitational force. When the gravitational force cannot be used dependent on an orientation of the translation apparatus TA2 or when the gravitational force is not large enough for a backward motion of the translation apparatus TA2, the translation apparatus TA2 may preferably further contain means for providing a reset force for a sliding unit of the translation apparatus TA2. The reset force may be provided for example by a fixation of the first extensible material EAP1 at the lower end face of the dividing wall DW and by a fixation of the second extensible material EAP2 at the cover of the third recipient by one of the means as being described with respect to the translation apparatus TA1. A further possibility for providing the reset force may be based on one or several springs as being described with respect to the translation apparatus TA1.

The translation apparatus TA2 may further contain the object OBJ outside the housing HS2 of the translation apparatus TA2 and attached to an outer surface of the housing HS2 in a same way as being described with respect to the translation apparatus TA1.

In a non-expanded state of the translation apparatus TA1 as shown in Figure 2 a), the first extensible material EAP1 and the second extensible material EAP2 may be fully compressed and the third recipient P3 is adapted to contain partly the second recipient P2 and the second recipient P2 is adapted to contain partly the first recipient P1. The non-expanded state of the translation apparatus TA2 may be obtained by a first predefined value of the output voltage of the first controllable voltage source VS1 to be applied to the first extensible material EAP1 and by a second predefined value of the output voltage of the second controllable voltage source VS2 to be applied to the second extensible material EAP2.

Figure 2 b) shows the translation apparatus TA2 in the fully-expanded state. The fully-expanded state of the translation apparatus TA2 may be obtained by a third predefined value of the output voltage of the first controllable voltage source VS1 larger than the first predefined value and by a fourth predefined value of the output voltage of the second controllable voltage source VS2 larger than the second predefined value. By the fully-expanded state, the second recipient P2 may be adapted to almost (except for a small overlap, which is used as a closure and lock) fully uncover the first recipient P1 and the third recipient P3 may be adapted to fully almost (except for a further small overlap, which is used as a further closure and further lock) uncover the second recipient P2 as shown in Figure 2 b). In the fully-expanded state the diving wall DW may be arranged for example at a half height of the second recipient P2 as shown in Figure 2 b).

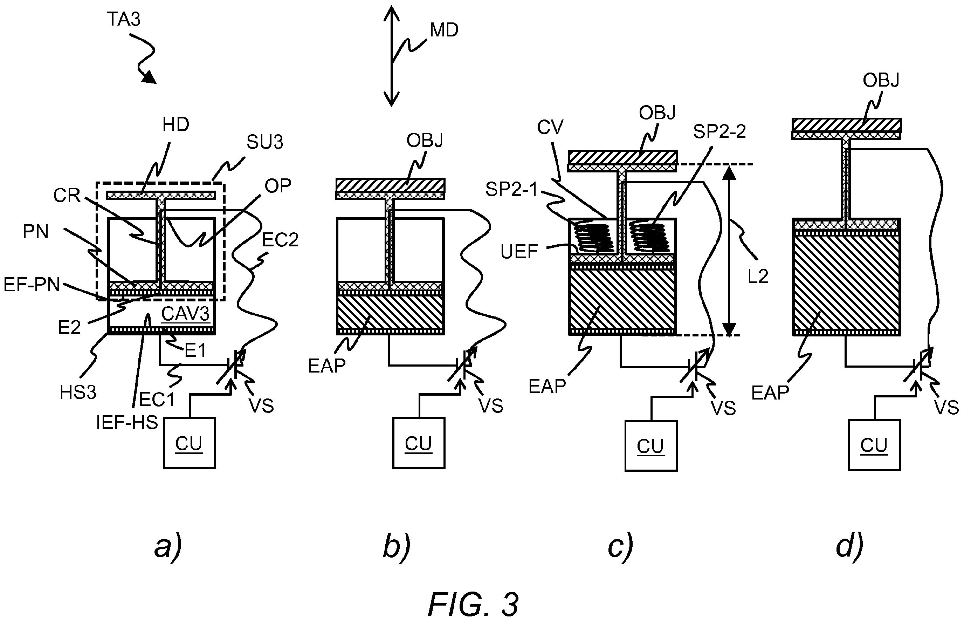

In a further embodiment for obtaining a sufficient length prolongation, a translation apparatus may contain a first set of two cup like or beaker like recipients, which are arranged in a manner as described with respect to Figure 1 but avoiding the recipient in the middle. The translation apparatus may further contain a second set of two recipients, which is stacked on the first set of the two recipients. In further embodiments, the translation apparatus may contain three sets stacked on each other, four sets stacked on each other or even more sets stacked on each other.Figure 3 shows schematically four block diagrams of a translation apparatus TA3 according to a third exemplary embodiment. The elements in Figure 3 that correspond to elements of Figure 1 have been designated by same reference numerals and will not be explained again in detail with respect to Figure 3 for simplification.

The translation apparatus TA3 which is shown in Figure 3 a) contains a housing HS3 with an opening OP in an upper part of the housing HS3 for a connecting rod CR. An outer diameter of the connecting rod CR may be adapted to a diameter of the opening OP. Preferably, a gap between the connecting rod CR and the opening OP may be sealed for example by an o-ring or an anti-friction agent such as oil may be inserted between the connecting rod CR and the opening OP. The housing HS3 may be for example a cylinder or a cuboid/an ashlar with a quadratic base area.

The housing HS3 may contain or may consist of a non-conductive material. Alternatively, the housing HS3 may contain or may consist of a conductive material and an inner surface of the housing HS3 may contain an isolation layer such as PTFE (PTFE = Polytetrafluorethylen), FEP (FEP = Fluorethylenpropylen), or PFA (PFA = Perfluorakoxy). Thereby, an electrical isolation between the conductive material of the housing HS3 and the extensible material EAP may be obtained. The housing HS3 may be a recipient, which may have for example a form of a cylinder, a cuboid or a cube.

The translation apparatus TA3 further contains a single piston PN inside the housing HS3. An outer circumference of the piston PN is adapted to an inner circumference of the housing HS3. A distance between the piston PN and the inner circumference of the housing HS3 may for example in a range of several micrometers so that the extensible material EAP being filled into the housing HS3 is not able to flow or pass over from a lower side of the piston PN to an opposite upper side of the piston PN. Furthermore, based on the distance between the piston PN and the inner circumference of the housing HS3 the piston PN is shiftable inside the housing HS3 and thereby the piston PN is adapted to move the movable part HD.

The translation apparatus TA3 further contains the connecting rod CR which may be part of the piston PN which means that the piston PN and the connecting rod CR may be a single part. Alternatively, the connecting rod CR may be connected to the piston PN for example by a screw connection. The connecting rod CR extends to an outer area of the housing HS2.

The translation apparatus TA3 further contains a movable part HD being externally arranged to the housing HS3 such as a holder for the object OBJ which may be part of the connecting rod CR which means that the holder and the connecting rod CR may be formed as a single part for example by a molding process or a casting process. Alternatively, the holder may be connected to the connecting rod CR for example by a further screw connection.

An inner lower part of the housing HS3 between a bottom of the housing HS3 and the piston PN provides a cavity CAV3 for the extensible material EAP.

The arrangement of the piston PN, the connecting rod CR and the holder HD adds up to a sliding unit SU3 as part of the translation apparatus TA3. Preferably, the sliding unit SU3 is adapted to move in a single linear movement direction being the movement direction MD by the expansion or by the contraction of the extensible material EAP.

The translation apparatus TA3 further contains the first electrode E1 preferably at a lower inner end face IEF-HS of the housing HS3 and the second electrode E2 preferably at the lower side of the piston PN facing towards the lower inner end face IEF-HS of the housing HS3. A surface of the lower inner end face IEF-HS is preferable arranged perpendicular to the movement direction MD. In alternative embodiments, at least one of the first electrode E1 and the second electrode E2 may be arranged at an inner surface of the recipient of the housing HS3 which has a surface normal being perpendicular arranged to the movement direction MD of the translation apparatus TA3.

The first electrode E1 is preferably arranged at a bottom of the housing HS2. The first electrode E1 may be for example a plane electrode with an outer diameter which is adapted and fits to an inner diameter of the housing HS3.

The first electrical connection EC1 to the first electrode E1 is preferably provided by a feed through via the bottom of the housing HS2 (see Figure 3 a).

The second electrode E2 is preferably arranged at the lower side or lower end face EF-PN of the piston PN which faces to the bottom of the housing HS2. The second electrode E2 may be for example a plane electrode with an outer diameter which is adapted and fits to an inner diameter of the housing HS3. A surface of the end face EF-PN of the piston PN is preferably arranged perpendicular to the movement direction MD.

The second electrical connection EC2 to the second electrode E2 is provided for example by a further feed through via the piston PN and a further feed through via an inner part of the connecting rod CR which may have an opening to the outer space near the holder HD and outside the housing HS2 (see Figure 2 a).

Alternatively, the connecting rod CR and the piston PN may be consist of a conductive material which is electrically isolated with respect to the housing HS3, which may consist of a same or different conductive material. Thereby, first electrical connection EC1 may be connected to the housing HS3 and the second electrical connection EC2 may be connected to the connecting rod CR. In such a case the first electrode E1 and the second electrode E2 may be not required because the housing HS3 provides a first electrical contact and the combination of the piston PN and the connecting rod CR provides a second electrical contact for the extensible material EAP. Only an electrical isolation between the combination of the piston PN and the connecting rod CR and the housing HS3 is required.

The translation apparatus TA3 may further contain the controllable voltage source VS and the control unit CU for controlling an output voltage of the controllable voltage source VS.

The translation apparatus TA3 which is shown in Figure 3 b) further contains the extensible material EAP which is filled into the cavity CAV3 of the housing HS3 and which is in contact with the first electrode E1 and the second electrode E2. The extensible material EAP is adapted to expand or to contract if the output voltage of the controllable voltage source VS is applied to the first electrode E1 and to the second electrode E2. Thereby, the sliding unit SU3 (i.e. the piston PN) is adapted to move in the movement direction MD by an expansion or by a contraction of the extensible material EAP. The expansion is achieved by an internal pressure, which is obtained when the extensible material EAP presses against the lower side of the piston PN. The contraction may be achieved for example by a gravitational force.. When the gravitational force cannot be used dependent on an orientation of the translation apparatus TA1 or when the gravitational force is not large enough for a backward motion of the sliding unit SU3, the translation apparatus TA3 may preferably further contain means for providing a reset force for the sliding unit SU3. The reset force may be provided for example by a fixation of the extensible material EAP at the lower end face EF-PN of the piston PN for example by one of the alternatives as described above with respect to Figure 1. A further possibility for providing the reset force is shown with respect to Figure 3 c) (only shown in Figure 3 c) for simplification). The translation apparatus TA3 may further contain a first spring SP2-1 and a second spring SP2-2, which are arranged between an upper end face UEF of the piston PN and a cover CV of the housing HS3. A combined reset force of the springs SP2-1, SP2-2 is below an expansion force of the extensible material EAP and above an inert force of the piston PN. In further embodiments, the translation apparatus TA3 may contain only a single spring or more than two springs.

The translation apparatus TA3 may further contain the object OBJ outside the housing HS3 of the translation apparatus TA3 and attached to the holder HD. A surface region of the holder HD may be preferably perpendicular arranged to the movement direction MD of the translation apparatus TA3. The object OBJ may be attached to the holder HD for example by an adhesive bond if for example an electrical isolation or a thermal isolation is required or may be affixed by a screw fitting.

In a non-expanded state of the translation apparatus TA3 as shown in Figure 3 b), the extensible material EAP may be fully compressed and the piston PN may be in a lowest position. The non-expanded state of the translation apparatus TA3 may be obtained by a further first predefined value of the output voltage of the controllable voltage source VS.

Figure 3 c) shows the translation apparatus TA3 in an intermediate state between the non-expanded state as shown in Figure 3 b) and a fully-expanded state as shown by Figure 3 d). The intermediate state with a desired length L2 of the translation apparatus TA3 between the bottom of the housing HS3 and an upper surface of the holder HD may be obtained by a further second predefined value of the output voltage of the controllable voltage source VS larger than the further first predefined value. In the intermediate state, the connecting rod CR has moved partially out of the housing HS3 as shown in Figure 3 c).

Figure 3 d) shows the translation apparatus TA3 in the fully-expanded state. The fully-expanded state may be obtained by a further third predefined value of the output voltage of the controllable voltage source VS larger than the further second predefined value.

By the fully-expanded state, an upper end position of the piston PN within the housing HS3 may be adapted to fully uncover the connecting rod CR and to dispense completely the connecting rod CR as shown in Figure 3 d).

An expansion or contraction of the translation apparatus TA3 may depend linearly from the output voltage of the controllable voltage source VS to be applied to the extensible material EAP. If alternatively, the expansion of the translation apparatus TA3 does not depend linearly from the output voltage of the controllable voltage source VS, a further value table may be applied within the control unit CU for adjusting the translation apparatus TA3 with the desired length L2.

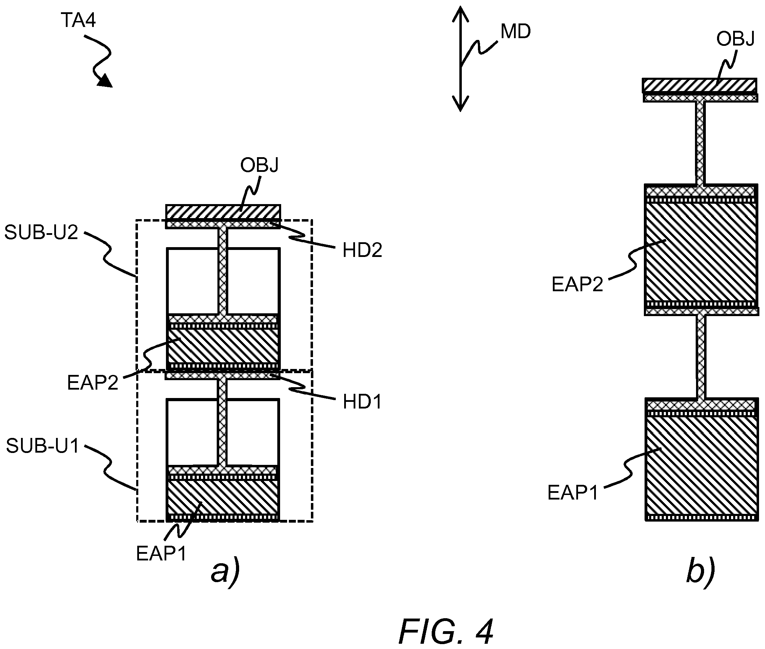

Figures 4 a) and 4 b) show schematically two block diagrams of a translation apparatus TA4 according to a fourth exemplary embodiment. Control unit, electrodes, voltage source and electrical connections are not shown in Figures 4 a) and 4 b) for simplification. These may be arranged and connected in a similar way as described with respect to Figures 2 a) and 2 b).

The translation apparatus TA4 contains a first subunit SUB-U1 and a second subunit SUB-U2. The first subunit SUB-U1 and the second subunit SUB-U2 may be for example the translation apparatus TA3 without the object OBJ. The second subunit SUB-U2 is mounted at a first holder HD1 of the first subunit SUB-U1. The object OBJ is mounted at a second holder HD2 of the second subunit SUB-U2. Thereby, an expansion range of the translation apparatus TA4 may be doubled with respect to an expansion range of the translation apparatus TA3.

If a translation in two dimensions or three dimensions may be required, a translation system may contain the translation apparatus and a further one or two further translation apparatuses which may be arranged in such a way, that the object may be mounted at a first translation apparatus and the first translation apparatus may be mounted at a second translation apparatus and perpendicular arranged with respect to the first translation apparatus for a movement in two dimensions or in addition the second translation apparatus may be mounted at a third translation apparatus and perpendicular arranged with respect to the second translation apparatus for a movement in three dimensions.

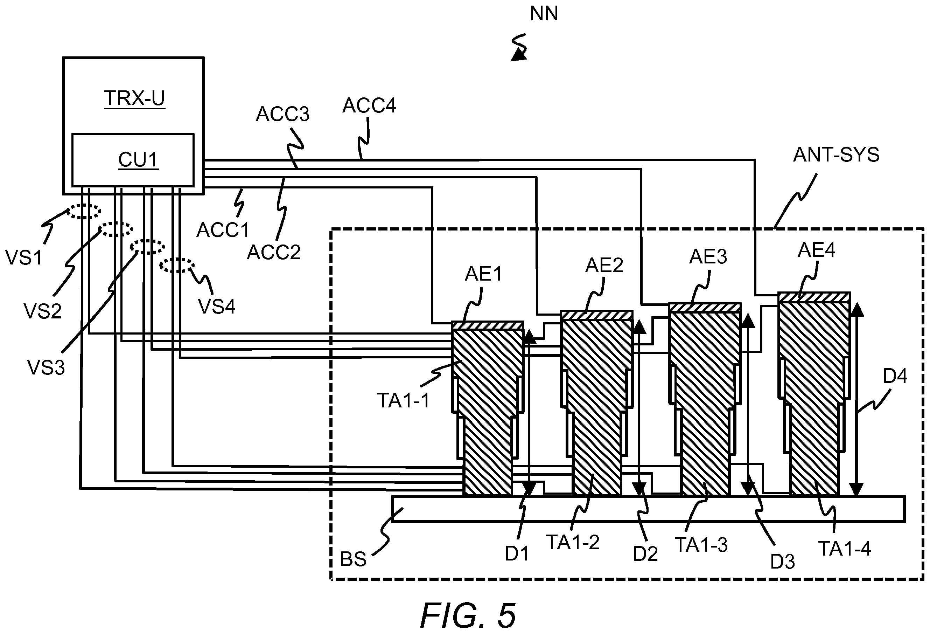

Figure 5 shows schematically a block diagram of network node NN for radio communication. The network node NN contains a transceiver unit TRX-U for generating and receiving radio frequency signals, an antenna system ANT-SYS for transmitting and receiving the radio frequency signals, signal connections ACC1, ACC2, ACC3, ACC4 between the transceiver unit TRX-U and the antenna system ANT-SYS and control connections VS1, VS2, VS3, VS4 between the transceiver unit TRX-U and the antenna system ANT-SYS.

The antenna system ANT-SYS contains a baseplate BS, a first translation apparatus TA1-1, a second translation apparatus TA1-2, a third translation apparatus TA1-3 and a fourth translation apparatus TA1-4, a first antenna element AE1 mounted at the first translation apparatus TA1-1, a second antenna element AE2 mounted at the second translation apparatus TA1-2, a third antenna element AE3 mounted at the third translation apparatus TA1-3 and a fourth antenna element AE4 mounted at the fourth translation apparatus TA1-4. This means, that the object shown in Figure 1 and Figure 2 is in each case one of the antenna elements AE1, AE2, AE3, AE4.

Alternatively, the antenna system ANT-SYS may contain only two antenna elements with each antenna element mounted to one translation apparatus, eight antenna elements with each antenna element mounted to one translation apparatus or sixteen antenna elements in a 4 x 4 arrangement and each antenna element mounted to one translation apparatus.

The translation apparatuses TA1-1, TA1-2, TA1-3, TA1-4 may be based on the translation apparatus TA1 as shown in Figure 1. Alternatively, the translation apparatuses TA1-1, TA1-2, TA1-3, TA1-4 may be based on one of the translation apparatuses TA2, TA3 or TA4 (see Figures 2 to 4).

For obtaining a first control connection VS1 a first voltage supply cable set is connected from the control unit CU1 to electrodes of the first translation apparatus TA1-1. In a same way, for obtaining a second control connection VS2 a second voltage supply cable set is connected from the control unit CU1 to electrodes of the second translation apparatus TA1-2, for obtaining a third control connection VS3 a third voltage supply cable set is connected from the control unit CU1 to electrodes of the third translation apparatus TA1-3 and for obtaining a fourth control connection VS4 a fourth voltage supply cable set is connected from the control unit CU1 to electrodes of the fourth translation apparatus TA1-4.

For obtaining a first signal connection ACC1 a first antenna connecting cable is connected from the transceiver unit TRX-U to the first antenna element AE1. In a same way, for obtaining a second signal connection ACC2 a second antenna connecting cable is connected from the transceiver unit TRX-U to the second antenna element AE2, for obtaining a third signal connection ACC3 a third antenna connecting cable is connected from the transceiver unit TRX-U to the third antenna element AE3 and for obtaining a fourth signal connection ACC4 a fourth antenna connecting cable is connected from the transceiver unit TRX-U to the fourth antenna element AE4.

The translation apparatuses TA1-1, TA1-2, TA1-3, TA1-4 may be mounted in each case with an outer surface of the bottom of the first piston P1 (see Figure 1) to the baseplate BS for example by a screw connection, by a mold connection or by an adhesive joint. With respect to Figure 3 a linear arrangement of the translation apparatuses TA1-1, TA1-2, TA1-3, TA1-4 with different distances D1, D2, D3, D4 of the antenna elements AE1, AE2, AE3, AE4 with respect to the baseplate BS is chosen. Thereby, the antenna system ANT-SYS may be adapted depending on a vertical or horizontal orientation of the antenna system ANT-SYS with respect to the Earth's surface to transmit/receive several radiation beams with different vertical angles or different horizontal angles.

For being able to adjust optimal radiation beam forms during an operation of the antenna system ANT-SYS, the antenna system ANT-SYS may be firstly measured/calibrated by sweeping different phase delays. Different control voltage values and related phase delays and preferably resulting radiation beam forms may be stored in a look-up table of the transceiver unit TRX-U, allowing applying appropriate control voltage values to the extensible material EAP (see Figure 1 and Figure 2), later in the field for different coverage scenarios.

According to further alternatives, the antenna system ANT-SYS may contain various numbers of translation apparatuses such as two translation apparatus in a linear arrangement, 16 translation apparatuses in 4 x 4 arrangement or 8 translation apparatuses in a linear arrangement.

The transceiver unit TRX-U contains besides conventional components of transceiver unit such as baseband board, digital-to-analogue converter(s), mixer(s) and power amplifier(s) (not shown in Figure 4 for simplification) in addition a control unit CU1. The control unit CU1 may be similar to the control CU shown in Figure 1 and Figure 3 but may be adapted to control output voltages for length adjustments of the translation apparatuses TA1-1, TA1-2, TA1-3, TA1-4.

The network node NN may be for example a base station, a repeater or relay.

The term "base station" may be considered synonymous to and/or referred to as a base transceiver station, access point base station, access point, macro base station and macro cell, micro base station and microcell, femto cell, pico cell etc. and may describe equipment that provides wireless connectivity via one or more radio links to one or more mobile stations. The base station may be for example an LTE Node B, an IEEE 802.11 access point, a WiMAX base station etc.

The term "macro base station" may be considered synonymous to and/or referred to a base station, which provides a radio cell having a size in a range of several hundred meters up to several kilometres. A macro base station usually has a maximum output power of typically tens of watts.

The term "micro base station" may be considered synonymous to and/or referred to a base station, which provides a radio cell having a size in a range of several tens of meters up to hundred meters. A micro base station usually has a maximum output power of typically several watts.

The term "macro cell" may be considered synonymous to and/or referred to a radio cell, which provides the widest range of all radio cell sizes. Macro cells are usually found in rural areas or along highways.

The term "micro cell" may be considered synonymous to and/or referred to a radio cell in a cellular network served by a low power cellular base station, covering a limited area (smaller than an area of a macro cell) such as a mall, a hotel, or a transportation hub. A microcell is referred to a group of radio cells, which contain pico cells and femto cells.

The term "pico cell" may be considered synonymous to and/or referred to a small cellular base station typically covering a small area, such as in-building (offices, shopping malls, train stations, stock exchanges, etc.), or more recently in-aircraft. In cellular networks, pico cells are typically used to extend coverage to indoor areas where outdoor signals do not reach well, or to add network capacity in areas with very dense phone usage, such as train stations.

The term "femto cell" may be considered synonymous to and/or referred to a small, low-power cellular base station, typically designed for use in a home or small business. A broader term which is more widespread in the industry is small cell, with femto cell as a subset.

The term "repeater" may be considered synonymous to and/or referred to as an electronic device that receives a signal and simply retransmits it at a higher level or higher power, or onto another side of an obstruction, so that the signal can cover longer distances.

The term "relay" may be considered synonymous to and/or referred to as an electronic radio communication device that receives a signal and retransmits a different signal not only at a higher level or higher power, but also at a different frequency and/or different time slot and/or spreading code, to increase capacity in a wireless access network and to improve wireless link performance.
The description and drawings merely illustrate the principles of the invention. It will thus be appreciated that those skilled in the art will be able to devise various arrangements that, although not explicitly described or shown herein, embody the principles of the invention. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions.

Functional blocks denoted as "means for performing a certain function" shall be understood as functional blocks comprising circuitry that is adapted for performing the certain function, respectively. Hence, a "means for something" may as well be understood as a "means being adapted or suited for something". A means being adapted for performing a certain function does, hence, not imply that such means necessarily is performing said function (at a given time instant).
Functions of various elements shown in the figures, including any functional blocks may be provided through the use of dedicated hardware, as e.g. a processor, as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "control unit" should not be construed to refer exclusively to hardware capable of executing software, and may implicitly include, without limitation, DSP hardware, network processor, ASIC, FPGA, read only memory (ROM) for storing software, random access memory (RAM), and non-volatile storage. Other hardware, conventional and/or custom, may also be included.
It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the detailed description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

## Claims

1. A translation apparatus (TA1, TA2, TA3, TA4) for moving an object (OBJ) outside a housing (HS1, HS2, HS3) of said translation apparatus (TA1, TA2, TA3, TA4) comprising:
- said housing (HS1, HS2, HS3) forming a cavity (CAV1, CAV2-1, CAV3),
- a first electrical contact surface (E1, E1-1) and a second electrical contact surface (E2, E1-2) inside said cavity (CAV1, CAV2-1, CAV3), and
- an extensible material (EAP, EAP1) filled into said cavity (CAV1, CAV2-1, CAV3) and in contact to said first electrical contact surface (E1, E1-1) and to said second electrical contact surface (E2, E1-2),
wherein said extensible material (EAP, EAP1) is adapted to expand or to contract if a control voltage is applied to said first electrical contact surface (E1, E1-1) and to said second electrical contact surface (E2, E1-2) and wherein said translation apparatus (TA1, TA2, TA3, TA4) is adapted to expand or to contract in a linear direction (MD) by an expansion or by a contraction of said extensible material (EAP, EAP1) **characterized in that**, said housing (HS1, HS2) comprises
a first recipient (P1) and at least one second recipient (P2, P3), wherein said first recipient (P1) is shiftable arranged in an opening of a base of said at least one second recipient (P2, P3), wherein said at least one second recipient (P2, P3) is adapted to contain at least partly said first recipient (P1) in a non-expanded state of said translation apparatus (TA1), and wherein said at least one second recipient (P2, P3) is adapted to uncover at least partly said first recipient (P1) in an expanded state of said translation apparatus (TA1).

2. Translation apparatus (TA1) according to claim 1, wherein said first recipient (P1) has a form of a first cup and wherein said at least second recipient (P2, P3) has a form of at least one second cup.

3. Translation apparatus (TA1) according to claim 1 or claim 2, wherein said first electrical contact surface (E1, E1-1) is a first electrode being arranged at a first inner end face (IEF1) of said housing (HS1), wherein said second electrical contact surface (E2, E1-2) is a second electrode being arranged at a second inner end face (IEF2) of said housing (HS1) opposite to said first inner end face (IEF1) and wherein a surface normal of said first inner end face (IEF1) and a further surface normal of said at least second inner end face (IEF2) are parallel arranged to said a linear direction (MD).

4. Translation apparatus (TA1, TA2, TA3, TA4) according to any of the preceding claims, wherein said translation apparatus (TA1, TA2, TA3, TA4) further comprises said object (OBJ) and wherein said object (OBJ) is mounted on a surface of said translation apparatus (TA1, TA2, TA3, TA4) having a surface normal being parallel arranged to said a linear direction (MD).

5. Translation apparatus (TA1, TA3) according to any of the preceding claims, wherein said translation apparatus (TA1, TA3) further comprises means for providing a reset force for a contraction of said translation apparatus (TA1, TA3) in said a linear direction (MD).

6. Translation apparatus (TA2, TA4) according to any of the preceding claims, said translation apparatus (TA2, TA4) further comprises:
- at least one further first electrical contact surface (E2-1) and at least one further second electrical contact surface (E2-2) arranged inside at least one further cavity (CAV2-2) of said housing (HS2),
- at least one further extensible material (EAP2) filled into said at least one further cavity (CAV2-2) and in contact to said at least one further first electrical contact surface (E2-1) and to said at least one further second electrical contact surface (E2-2),
wherein said at least one further extensible material (EAP2) is adapted to expand or to contract if at least one further control voltage is applied to said at least one further first electrical contact surface (E2-1) and to said at least one further second electrical contact surface (E2-2) and wherein said extensible material (EAP1) and said at least one further extensible material (EAP2) are stacked in said housing (HS2) in a direction parallel to said a linear direction (MD).

7. Translation apparatus (TA2, TA4) according to claim 6, wherein a voltage at said first electrode (E1, E1-1) and said second electrode (E2, E1-2) is controllable by a first voltage source (VS1) and wherein a further voltage at said at least one further first electrode (E2-1) and said at least one further second electrode (E2-2) is controllable by at least one further voltage source (VS2).

8. Translation apparatus (TA1, TA2, TA3, TA4) according to any of the preceding claims, wherein said housing (HS1, HS2, HS3) comprises a non-conductive material or wherein said housing (HS1, HS2, HS3) comprises a conductive material and wherein an inner surface of said housing (HS1, HS2, HS3) comprises an isolation layer between said conductive material and said extensible material (EAP).

9. Translation apparatus (TA1, TA2, TA3, TA4) according to any of the preceding claims, wherein said extensible material (EAP) is either of the following:
- an ionic electro-active polymer,
- a dielectric electro-active polymer,
- an ionic polymer metal composite),
- a polyacrylamide and polayacrylic acid cross- linked gel,
- a carbon nanotube based EAP,
- a very high bond tape,
- VHB-TMPTMA interpenetration network.

10. A translation system comprising at least two translation apparatuses according to any of the preceding claims 1 to 9, wherein a first one of said at least two translation apparatuses is mounted at a second one of said at least two translation apparatuses and wherein an expansion direction of said first one of said at least two translation apparatuses is perpendicular arranged with respect to a further expansion direction of said second one of said at least two translation apparatuses for a movement of said object in a first direction and at least one second direction being perpendicular to said first direction.

11. An RF component (ANT-SYS) for mobile communication comprising at least one translation apparatus (TA1-1, TA1-2, TA1-3, TA1-4) according to one of preceding claims 1 to 9 and wherein said at least one translation apparatus (TA1-1, TA1-2, TA1-3, TA1-4) is adapted for adjusting a position or orientation of at least one subunit (AE1, AE2, AE3, AE4) of said RF component (ANT-SYS).

12. RF component (ANT-SYS) according to claim 11, wherein said RF component (ANT-SYS) is an antenna system and wherein said at least one subunit (AE1, AE2, AE3, AE4) is at least one antenna element.

## Patentansprüche

1. Übersetzungsvorrichtung (TA1, TA2, TA3, TA4) zum Bewegen eines Objektes (OBJ) außerhalb eines Gehäuses (HS1, HS2, HS3) von besagter Übersetzungsvorrichtung (TA1, TA2, TA3, TA4) umfassend:
- besagtes Gehäuse (HS1, HS2, HS3), das einen Hohlraum (CAV1, CAV2-1, CAV3) bildet,
- eine erste elektrische Kontaktfläche (E1, E1-1) und eine zweite elektrische Kontaktfläche (E2, E1-2) innerhalb des besagten Hohlraums (CAV1, CAV2-1, CAV3), und
- ein dehnbares Material (EAP, EAP1), gefüllt in besagten Hohlraum (CAV1, CAV2-1, CAV3) und in Kontakt mit besagter ersten elektrischen Kontaktfläche (E1, E1-1) und mit besagter zweiten elektrischen Kontaktfläche (E2, E1-2),
wobei besagtes dehnbares Material (EAP, EAP1) angepasst ist zum Expandieren oder Kontrahieren, wenn eine Steuerspannung auf besagte erste elektrische Kontaktfläche (E1, E1-1) und auf besagte zweite elektrische Kontaktfläche (E2, E1-2) angelegt wird, und wobei besagte Übersetzungsvorrichtung (TA1, TA2, TA3, TA4) angepasst ist zum Expandieren oder Kontrahieren in einer linearen Richtung (MD) durch die Expansion oder Kontraktion von besagtem dehnbaren Material (EAP, EAP1),
**dadurch gekennzeichnet, dass**
besagtes Gehäuse (HS1, HS2) einen ersten Empfänger (P1) umfasst und mindestens einen zweiten Empfänger (P2, P3), wobei besagter erster Empfänger (P1) verschiebbar angeordnet ist in einer Öffnung einer Basis des mindestens einen zweitem Empfängers (P2, P3), wobei der mindestens eine zweite Empfänger (P2, P3) angepasst ist, um mindestens teilweise besagten ersten Empfänger (P1) in einem nicht-expandierten Zustand von besagter Übersetzungsvorrichtung (TA1) zu enthalten, und wobei der mindestens eine zweite Empfänger (P2, P3) angeordnet ist, um mindestens teilweise besagten ersten Empfänger (P1) in einem expandierten Zustand von besagter Übersetzungsvorrichtung (TA1) freizulegen.

2. Übersetzungsvorrichtung (TA1) nach Anspruch 1, wobei besagter erster Empfänger (P1) die Form einer ersten Schale aufweist und wobei besagter mindestens zweiter Empfänger (P2, P3) die Form von mindestens einer zweiten Schale aufweist.

3. Übersetzungsvorrichtung (TA1) nach Anspruch 1 oder Anspruch 2, wobei besagte erste elektrische Kontaktfläche (E1, E1-1) eine erste Elektrode ist, die angeordnet ist an einer ersten inneren Endfläche (IEF1) von besagtem Gehäuse (HS1), wobei besagte zweite elektrische Kontaktfläche (E2, E1-2) eine zweite Elektrode ist, angeordnet an einer zweiten inneren Endfläche (IEF2) von besagtem Gehäuse (HS1), gegenüberliegend von besagter ersten inneren Endfläche (IEF1), und wobei eine Flächennormale von besagter ersten inneren Endfläche (IEF1) und eine weitere Flächennormale von besagter mindestens zweiten inneren Endfläche (IEF2) parallel zu besagter linearer Richtung (MD) angeordnet sind.

4. Übersetzungsvorrichtung (TA1, TA2, TA3, TA4) nach einem beliebigen der vorstehenden Ansprüche, wobei besagte Übersetzungsvorrichtung (TA1, TA2, TA3, TA4) ferner besagtes Objekt (OBJ) umfasst und wobei besagtes Objekt (OBJ) auf einer Fläche von besagter Übersetzungsvorrichtung (TA1, TA2, TA3, TA4) montiert ist mit einer Flächennormale, die parallel zu besagter linearer Richtung (MD) angeordnet ist.

5. Übersetzungsvorrichtung (TA1, TA3) nach einem beliebigen der vorstehenden Ansprüche, wobei besagte Übersetzungsvorrichtung (TA1, TA3) ferner Mittel umfasst zum Bereitstellen einer Rückstellkraft für eine Kontraktion von besagter Übersetzungsvorrichtung (TA1, TA3) in besagter linearer Richtung (MD).

6. Übersetzungsvorrichtung (TA2, TA4) nach einem beliebigen der vorstehenden Ansprüche, wobei besagte Übersetzungsvorrichtung (TA2, TA4) ferner umfasst:
- mindestens eine weitere erste elektrische Kontaktfläche (E2-1) und mindestens eine weitere zweite elektrische Kontaktfläche (E2-2), angeordnet innerhalb des mindestens einen weiteren Hohlraums (CAV2-2) von besagtem Gehäuse (HS2),
- mindestens ein weiteres dehnbares Material (EAP2), gefüllt in den mindestens einen weiteren Hohlraum (CAV2-2) und in Kontakt mit der mindestens einen weiteren ersten elektrischen Kontaktfläche (E2-1) und der mindestens einen weiteren zweiten elektrische Kontaktfläche (E2-2),
wobei das mindestens eine weitere dehnbare Material (EAP2) angepasst ist zum Expandieren oder Kontrahieren, wenn mindestens eine weitere Steuerspannung auf die mindestens eine weitere erste elektrische Kontaktfläche (E2-1) und auf die mindestens eine weitere zweite elektrische Kontaktfläche (E2-2) angelegt wird, und wobei besagtes dehnbares Material (EAP1) und das mindestens eine weitere dehnbare Material (EAP2) in besagtem Gehäuse (HS2) gestapelt sind in einer Richtung, die parallel zu einer linearen Richtung (MD) ist.

7. Übersetzungsvorrichtung (TA2, TA4) nach Anspruch 6, wobei eine Spannung an besagter erster Elektrode (E1, E1-1) und an besagter zweiter Elektrode (E2, E1-2) steuerbar ist durch eine erste Spannungsquelle (VS1) und wobei eine weitere Spannung an der mindestens einen weiteren ersten Elektrode (E2-1) und an der mindestens einen weiteren zweiten Elektrode (E2-2) steuerbar ist durch mindestens eine weitere Spannungsquelle (VS2).

8. Übersetzungsvorrichtung (TA1, TA2, TA3, TA4) nach einem beliebigen der vorstehenden Ansprüche, wobei besagtes Gehäuse (HS1, HS2, HS3) ein nichtleitendes Material umfasst oder wobei besagtes Gehäuse (HS1, HS2, HS3) ein leitendes Material umfasst und wobei eine innere Fläche von besagtem Gehäuse (HS1, HS2, HS3) eine Isolierschicht zwischen besagtem leitenden Material und besagtem dehnbaren Material (EAP) umfasst.

9. Übersetzungsvorrichtung (TA1, TA2, TA3, TA4) nach einem beliebigen der vorstehenden Ansprüche, wobei besagtes dehnbares Material (EAP) eines der folgenden ist:
- ein ionisches elektroaktives Polymer,
- ein dielektrisches elektroaktives Polymer,
- ein ionischer Polymer-Metallverbundstoff,
- ein vernetztes Polyacrylamid- und Polyacrylsäuregel,
- ein Kohlenstoff-Nanoröhren-basiertes EAP,
- ein Streifen mit sehr hoher Klebekraft,
- VHB-TMPTMA-Durchdringungs-Netzwerk.

10. Übersetzungssystem umfassend mindestens zwei Übersetzungsvorrichtungen nach einem der Ansprüche 1 bis 9, wobei eine erste der besagten mindestens zwei Übersetzungsvorrichtungen montiert ist auf einer zweiten der besagten mindestens zwei Übersetzungsvorrichtungen und wobei eine Expansionsrichtung von besagter ersten von besagten mindestens zwei Übersetzungsvorrichtungen vertikal angeordnet ist in Bezug auf eine weitere Expansionsrichtung von besagter zweiten der besagten mindestens zwei Übersetzungsvorrichtungen für die Bewegung von besagtem Objekt in eine erste Richtung und mindestens eine zweite Richtung, die vertikal zur besagten ersten Richtung ist.

11. Funkfrequenz-Komponente (ANT-SYS) für mobile Kommunikation, umfassend mindestens eine Übersetzungsvorrichtung (TA1-1, TA1-2, TA1-3, TA1-4) nach einem der vorstehenden Ansprüche 1 bis 9 und wobei die mindestens eine Übersetzungsvorrichtung (TA1-1, TA1-2, TA1-3, TA1-4) angepasst ist zum Einstellen einer Position oder Ausrichtung von mindestens einer Teileinheit (AE1, AE2, AE3, AE4) von besagter Funkfrequenz-Komponente (ANT-SYS).

12. Funkfrequenz-Komponente (ANT-SYS) nach Anspruch 11, wobei besagte Funkfrequenz-Komponente (ANT-SYS) ein Antennensystem ist und wobei die mindestens eine Teileinheit (AE1, AE2, AE3, AE4) mindestens ein Antennenelement ist.

## Revendications

1. Appareil de translation (TA1, TA2, TA3, TA4) pour déplacer un objet (OBJ) à l'extérieur d'un boîtier (HS1, HS2, HS3) dudit appareil de translation (TA1, TA2, TA3, TA4) comprenant :
- ledit boîtier (HS1, HS2, HS3) formant une cavité (CAV1, CAV2-1, CAV3),
- une première surface de contact électrique (E1, E1-1) et une deuxième surface de contact électrique (E2, E1-2) à l'intérieur de ladite cavité (CAV1, CAV2-1, CAV3), et
- un matériau extensible (EAP, EAP1) remplissant ladite cavité (CAV1, CAV2-1, CAV3) et en contact avec ladite première surface de contact électrique (E1, E1-1) et avec ladite deuxième surface de contact électrique (E2, E1-2),
dans lequel ledit matériau extensible (EAP, EAP1) est adapté pour se dilater ou pour se contracter si une tension de commande est appliquée à ladite première surface de contact électrique (E1, E1-1) et à ladite deuxième surface de contact électrique (E2, E1-2) et ledit appareil de translation (TA1, TA2, TA3, TA4) étant adapté pour se dilater ou pour se contracter dans une direction linéaire (MD) par une dilatation ou par une contraction dudit matériau extensible (EAP, EAP1),
**caractérisé en ce que**,
ledit boîtier (HS1, HS2) comprend un premier récipient (P1) et au moins un deuxième récipient (P2, P3), dans lequel ledit premier récipient (P1) est disposé de manière à pouvoir être déplacé dans une ouverture d'une base dudit au moins un deuxième récipient (P2, P3), dans lequel ledit au moins un deuxième récipient (P2, P3) est adapté pour contenir au moins partiellement ledit premier récipient (P1) dans un état non dilaté dudit appareil de translation (TA1), et dans lequel ledit au moins un deuxième récipient (P2, P3) est adapté pour découvrir au moins partiellement ledit premier récipient (P1) dans un état dilaté dudit appareil de translation (TA1).

2. Appareil de translation (TA1) selon la revendication 1, dans lequel ledit premier récipient (P1) a une forme de première coupe et dans lequel ledit au moins un deuxième récipient (P2, P3) a une forme d'au moins une deuxième coupe.

3. Appareil de translation (TA1) selon la revendication 1 ou la revendication 2, dans lequel ladite première surface de contact électrique (E1, E1-1) est une première électrode disposée au niveau d'une première face d'extrémité intérieure (IEF1) dudit boîtier (HS1), dans lequel ladite deuxième surface de contact électrique (E2, E1-2) est une deuxième électrode disposée au niveau d'une deuxième face d'extrémité intérieure (IEF2) dudit boîtier (HS1) opposée à ladite première face d'extrémité intérieure (IEF1) et dans lequel une surface perpendiculaire à ladite première face d'extrémité intérieure (IEF1) et une autre surface perpendiculaire à ladite au moins une deuxième face d'extrémité intérieure (IEF2) sont disposées parallèlement à ladite direction linéaire (MD).

4. Appareil de translation (TA1, TA2, TA3, TA4) selon l'une quelconque des revendications précédentes, ledit appareil de translation (TA1, TA2, TA3, TA4) comprenant en outre ledit objet (OBJ) et dans lequel ledit objet (OBJ) est monté sur une surface dudit appareil de translation (TA1, TA2, TA3, TA4) ayant une surface perpendiculaire disposée parallèlement à ladite direction linéaire (MD).

5. Appareil de translation (TA1, TA3) selon l'une quelconque des revendications précédentes, ledit appareil de translation (TA1, TA3) comprenant en outre des moyens pour fournir une force de réinitialisation pour une contraction dudit appareil de translation (TA1, TA3) dans ladite direction linéaire (MD).

6. Appareil de translation (TA2, TA4) selon l'une quelconque des revendications précédentes, ledit appareil de translation (TA2, TA4) comprenant en outre :
- au moins une autre première surface de contact électrique (E2-1) et au moins une autre deuxième surface de contact électrique (E2-2) disposées à l'intérieur d'au moins une autre cavité (CAV2-2) dudit boîtier (HS2),
- au moins un autre matériau extensible (EAP2) remplissant ladite au moins une autre cavité (CAV2-2) et en contact avec ladite au moins une autre première surface de contact électrique (E2-1) et avec ladite au moins une autre deuxième surface de contact électrique (E2-2),
dans lequel ledit au moins un autre matériau extensible (EAP2) est adapté pour se dilater ou pour se contracter si au moins une autre tension de commande est appliquée à ladite au moins une autre première surface de contact électrique (E2-1) et à ladite au moins une autre deuxième surface de contact électrique (E2-2) et dans lequel ledit matériau extensible (EAP1) et ledit au moins un autre matériau extensible (EAP2) sont empilés dans ledit boîtier (HS2) dans une direction parallèle à ladite direction linéaire (MD).

7. Appareil de translation (TA2, TA4) selon la revendication 6 dans lequel une tension au niveau de ladite première électrode (E1, E1-1) et de ladite deuxième électrode (E2, E1-2) peut être régulée par une première source de tension (VS1) et dans lequel une autre tension au niveau de ladite au moins une autre première électrode (E2-1) et de ladite au moins une autre deuxième électrode (E2-2) peut être régulée par au moins une autre source de tension (VS2).

8. Appareil de translation (TA1, TA2, TA3, TA4) selon l'une quelconque des revendications précédentes, dans lequel ledit boîtier (HS1, HS2, HS3) comprend un matériau non conducteur ou dans lequel ledit boîtier (HS1, HS2, HS3) comprend un matériau conducteur et dans lequel une surface intérieure dudit boîtier (HS1, HS2, HS3) comprend une couche d'isolation entre ledit matériau conducteur et ledit matériau extensible (EAP).

9. Appareil de translation (TA1, TA2, TA3, TA4) selon l'une quelconque des revendications précédentes, dans lequel ledit matériau extensible (EAP) est l'un quelconque des éléments suivants :
- un polymère électroactif ionique,
- un polymère électroactif diélectrique,
- un composite métal-polymère ionique,
- un gel réticulé de polyacrylamide et d'acide polyacrylique,
- un EAP à base de nanotube de carbone,
- un ruban hautement adhésif,
- un réseau d'interpénétration de VHB-TMPTMA.

10. Système de translation comprenant au moins deux appareils de translation selon l'une quelconque des revendications précédentes 1 à 9 dans lequel un premier appareil parmi lesdits au moins deux appareils de translation est monté au niveau d'un deuxième appareil parmi lesdits au moins deux appareils de translation et dans lequel une direction de dilatation dudit premier appareil parmi lesdits au moins deux appareils de translation est disposée perpendiculairement à une autre direction de dilatation dudit deuxième appareil parmi lesdits au moins deux appareils de translation pour un mouvement dudit objet dans une première direction et dans au moins une deuxième direction perpendiculaire à ladite première direction.

11. Composant RF (ANT-SYS) pour une communication mobile comprenant au moins un appareil de translation (TA1-1, TA1-2, TA1-3, TA1-4) selon l'une des revendications précédentes 1 à 9 et dans lequel ledit au moins un appareil de translation (TA1-1, TA1-2, TA1-3, TA1-4) est adapté pour ajuster une position ou une orientation d'au moins une sous-unité (AE1, AE2, AE3, AE4) dudit composant RF (ANT-SYS).

12. Composant RF (ANT-SYS) selon la revendication 11, dans lequel ledit composant RF (ANT-SYS) est un système d'antenne et dans lequel ladite au moins une sous-unité (AE1, AE2, AE3, AE4) est au moins un élément d'antenne.
